(19) Europäisches Patentamt / European Patent Office / Office européen des brevets

(11) **EP 3 059 744 B1**

(12) **EUROPEAN PATENT SPECIFICATION**

(45) Date of publication and mention
of the grant of the patent:
**26.02.2020 Bulletin 2020/09**

(51) Int Cl.:
**B22F 1/00** *(2006.01)*          **C22C 33/02** *(2006.01)*
**H01F 1/28** *(2006.01)*          **H05K 1/16** *(2006.01)*
**H05K 3/28** *(2006.01)*          **B22F 7/04** *(2006.01)*

(21) Application number: **14850860.9**

(22) Date of filing: **18.09.2014**

(86) International application number:
**PCT/JP2014/074633**

(87) International publication number:
**WO 2015/049991 (09.04.2015 Gazette 2015/14)**

(54) **SOFT MAGNETIC PARTICLE POWDER, SOFT MAGNETIC RESIN COMPOSITION, SOFT MAGNETIC FILM, SOFT MAGNETIC FILM LAMINATED CIRCUIT BOARD, AND POSITION DETECTION DEVICE**

PULVER AUS WEICHEN MAGNETISCHEN TEILCHEN, ZUSAMMENSETZUNG MIT WEICHEN MAGNETISCHEN TEILCHEN, WEICHER MAGNETISCHER FILM, MIT DEM WEICHEN MAGNETISCHEN FILM BESCHICHTETE LEITERPLATTE SOWIE POSITIONSERKENNUNGSVORRICHTUNG

POUDRE DE PARTICULES MAGNÉTIQUES À FAIBLE CHAMP COERCITIF, COMPOSITION DE RÉSINE MAGNÉTIQUE À FAIBLE CHAMP COERCITIF, FILM MAGNÉTIQUE À FAIBLE CHAMP COERCITIF, CARTE DE CIRCUITS IMPRIMÉS STRATIFIÉE ET DISPOSITIF DE DÉTECTION DE POSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **01.10.2013 JP 2013206709**
**29.08.2014 JP 2014175474**

(43) Date of publication of application:
**24.08.2016 Bulletin 2016/34**

(73) Proprietor: **Nitto Denko Corporation**
**Ibaraki-shi, Osaka 567-8680 (JP)**

(72) Inventors:
• **MASUDA, Shotaro**
**Ibaraki-shi**
**Osaka 567-8680 (JP)**
• **EBE, Hirofumi**
**Ibaraki-shi**
**Osaka 567-8680 (JP)**
• **HABU, Takashi**
**Ibaraki-shi**
**Osaka 567-8680 (JP)**

• **MATSUTOMI, Akihito**
**Ibaraki-shi**
**Osaka 567-8680 (JP)**

(74) Representative: **Hoffmann Eitle**
**Patent- und Rechtsanwälte PartmbB**
**Arabellastraße 30**
**81925 München (DE)**

(56) References cited:
**JP-A- H0 641 602          JP-A- H06 149 450**
**JP-A- H11 260 616          JP-A- 2005 194 565**
**JP-A- 2006 135 136          JP-A- 2008 115 404**
**JP-A- 2009 059 753          JP-A- 2009 267 237**
**JP-A- 2012 212 790          US-A- 5 651 841**

• **YUICHI SATO ET AL.: 'Classification mechanism of an air classifier using centrifugal force (Part 3' JOURNAL OF THE SOCIETY OF POWDER TECHNOLOGY vol. 27, no. 4, 1990, JAPAN, pages 225 - 230, XP055331238**

**Description**

TECHNICAL FIELD

The present invention relates to soft magnetic particle powder, and a soft magnetic resin composition, soft magnetic film, soft magnetic film laminated circuit board, and position detection device produced by using the soft magnetic particle powder.

BACKGROUND ART

Recently, electronic devices such as personal computers and smartphones are equipped with functions of wireless communications and wireless power transmission. In electronic devices, for broadening distance of wireless communication, better efficiency, and a smaller size, a magnetic film for convergence of magnetic flux is disposed around an antenna or coil included in the electronic device (for example, see Patent Document 1).

Patent Document 1 discloses a flexible magnetic film formed by blending flat soft magnetic powder with a binder.

Meanwhile, for improvement in convergence efficiency of magnetic flux, it is important to improve relative magnetic permeability (magnetic properties) of the magnetic film. Generally, increasing the thickness of the magnetic film improves relative magnetic permeability. However, because a small-sized electronic device and furthermore, a thin magnetic film are demanded, it is difficult to meet the demand of a smaller thickness with the above-described method.

Therefore, a method (highly filling) for increasing the soft magnetic particle volume percentage of the magnetic film has been known. However, even if the soft magnetic particles are simply charged in the magnetic film to give a high soft magnetic particle content, there are gaps (voids) created in the magnetic film, and therefore it is not easy to highly fill the magnetic film with the soft magnetic particle.

Thus, Patent Document 2 discloses an electromagnetic interference suppressor highly filled with soft magnetic particles by dispersing, as an ingredient material, soft magnetic powder to which a surface treatment is given by using a surface treatment agent containing Si elements.

JP 06-041602 A relates to a flat soft magnetic alloy powder having $\geq 20\mu$m grain diameter and $\leq 1\mu$m average thickness, which does not contain powdery grains having $\geq 88\mu$m diameter, and wherein the grains having 62-88 $\mu$m diameter are controlled to $\leq 1$vol.%.

JP 2005 41602 A relates to a method of producing soft magnetic alloy powder that is characterized in that a rapidly cooled thin strip containing Fe, Si, Al, Nb and B and composed of an amorphous phase as the main phase is subjected to pulverizing treatment or pulverizing and flattening treatment before heat-treatment to obtain an amorphous alloy powder. The amorphous alloy powder further is heat-treated at a prescribed temperature to precipitate a microcrystal grain structure with a mean grain size of $\leq 100$ nm into the structure.

JP H 11 260616 A relates to a method of manufacturing a soft magnetic foil, wherein heat treatment is employed in order to increase the crystal grain size.

JP 2009267237 A relates to a manufacturing method for a laminate soft magnetic sheet. The method includes: a step (A) of obtaining a hardening soft magnetic sheet by applying a soft magnetic composition obtained by mixing soft magnetic powder of flat particles, acrylic rubber having a glycidyl group, epoxy resin, a latent curing agent, and a solvent, onto a release base and drying the soft magnetic composition at a temperature T1 at which a curing reaction does not occur substantially; a step (B) of preparing two or more hardening soft magnetic sheets and laminating them to obtain a laminate; a step (C) of compressing the obtained laminate through release sheets disposed on both surfaces of the laminate, at a temperature T2 at which the curing reaction does not occur substantially, sequentially under linear pressures P1, P2, and P3 (P1<P2<P3) by a laminator applying the linear pressures; and a step (D) of compressing the compressed laminate through the release sheets disposed on both surfaces, at a temperature T3 at which the curing reaction occurs, by a press machine applying a surface pressure and hardening the compressed laminate to obtain the laminate soft magnetic sheet.

US 5,651,481 relates to a powder magnetic core having reduced core losses and increased mechanical strength, which is provided at low costs.

Citation List

Patent Document

Patent Document 1: Japanese Unexamined Patent Publication No.2006-39947
Patent Document 2: Japanese Unexamined Patent Publication No.2005-310952

## SUMMARY OF THE INVENTION

### PROBLEM TO BE SOLVED BY THE INVENTION

However, there are many voids generated inside the electromagnetic interference suppressor of Patent Document 2, and therefore the electromagnetic interference suppressor is insufficiently filled, and further improvement is required.

An object of the present invention is to provide soft magnetic particle powder that can be contained in the soft magnetic film with a high filling rate, a soft magnetic resin composition, soft magnetic film, soft magnetic film laminated circuit board, and position detection device produced by using the soft magnetic particle powder.

### MEANS FOR SOLVING THE PROBLEM

Soft magnetic particle powder of the present invention is soft magnetic particle powder composed of flat soft magnetic particles, and the soft magnetic particle powder has a kurtosis of more than -0.35, characterized in that the soft magnetic particle powder has a particle size $D_{10}$ and a particle size $D_{50}$ measured by a laser diffraction particle size distribution analyzer satisfying formula below: $D_{10}/D_{50} > 0.45$, with $D_{50}$ being 70 $\mu$m or more, and $D_{10}$ being 30 $\mu$m or more, and a kurtosis is determined by calculating a moment relative to the average value using the following formula:

$$\text{(Kurtosis)} = \frac{\sum \left| f_i \left( \ln x_i - \ln \bar{x} \right)^4 \right|}{\left( \ln SD^4 \sum f_i \right)} - 3$$

$X_i$ represents an average value of particle size of i-th channel (predetermined region on x-axis)
$\overline{X}$ represents average particle size
$f_i$ represents volume percentage of the particle
$SD$ represents standard deviation and is represented by formula below

$$SD = \exp\left[ \sqrt{\frac{\sum \left| f_i \left( \ln x_i - \ln \bar{x} \right)^2 \right|}{\sum f_i}} \right]$$

.

A soft magnetic resin composition of the present invention contains the soft magnetic particle powder and a resin component.

It is preferable that in the soft magnetic resin composition of the present invention, the resin component contains epoxy resin, phenol resin, and acrylic resin.

A soft magnetic film of the present invention is formed from the above-described soft magnetic resin composition.

A soft magnetic film laminated circuit board of the present invention is produced by laminating the soft magnetic film on a circuit board.

A position detection device of the present invention includes the soft magnetic film laminated circuit board.

### EFFECT OF THE INVENTION

The soft magnetic particle powder of the present invention is soft magnetic particle powder composed of flat soft magnetic particles, and the soft magnetic particle powder has a kurtosis of more than -0.35. Therefore, the soft magnetic resin composition and soft magnetic film of the present invention containing the soft magnetic particle powder can contain the soft magnetic particles with a high filling rate, and have excellent relative magnetic permeability.

Therefore, the soft magnetic film laminated circuit board and position detection device of the present invention including the soft magnetic film can achieve high efficiency.

BRIEF DESCRIPTION OF THE DRAWINGS

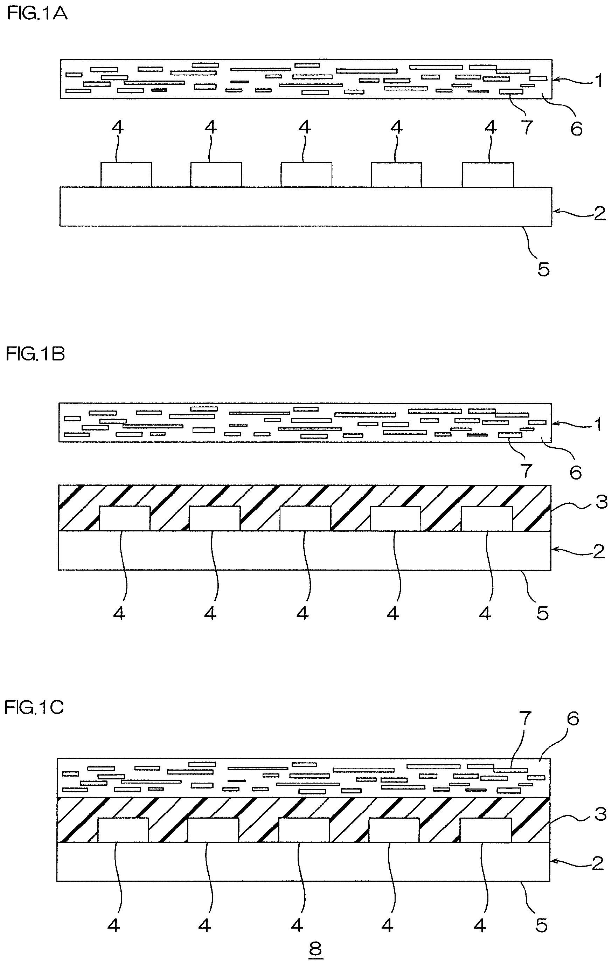

[FIG. 1]FIG. 1A to 1C are production process diagrams of an embodiment of the soft magnetic film laminated circuit board of the present invention, FIG. 1A showing a step of preparing a soft magnetic film and a circuit board, FIG. 1B showing a step of laminating an adhesive layer on a circuit board, and FIG. 1C showing a step of laminating a soft magnetic film on the adhesive layer.

DESCRIPTION OF EMBODIMENTS

1. Soft Magnetic Particle Powder

The soft magnetic particle powder of the present invention is composed of flat soft magnetic particles.

The soft magnetic particles are particles having a coercive force of, for example, 10A/m or more (preferably 50A/m or more), 1000A/m or less (preferably 200A/m or less), and examples of its soft magnetic material include magnetic stainless steel (Fe-Cr-Al-Si alloy), Sendust (Fe-Si-Al alloy), Permalloy (Fe-Ni alloy), silicon copper (Fe-Cu-Si alloy), Fe-Si alloy, Fe-Si-B (-Cu-Nb) alloy, Fe-Si-Cr-Ni alloy, Fe-Si-Cr alloy, Fe-Si-Al-Ni-Cr alloy, and ferrite.

Among these, preferably, Sendust (Fe-Si-Al alloy) is used. More preferably, a Fe-Si-Al alloy having a Si content of 9 to 15 mass% is used. Use of these allows the soft magnetic film to have excellent magnetic permeability.

The soft magnetic particles are formed into flat (platy), that is, formed to have a small thickness and a wide plane. The soft magnetic particle powder has an aspect ratio of, for example, 8 or more, preferably 15 or more, and for example, 80 or less, preferably 65 or less. The aspect ratio is calculated, for example, as an aspect ratio by dividing the particle size $D_{50}$ (described later) of the soft magnetic particles with the average thickness of the soft magnetic particles.

The soft magnetic particle powder has a kurtosis of more than -0.35, preferably 0.1 or more. The soft magnetic particle powder has a kurtosis of, for example, 5.0 or less, preferably 1.0 or less, more preferably 0.5 or less. The kurtosis of the soft magnetic particle powder within the above-described range allows for highly filled soft magnetic particles in the soft magnetic film, and a thin soft magnetic film.

The kurtosis is a value that represents peakedness in distribution, and a larger value represents a sharp peak considering peakedness of normal distribution as 0.

The kurtosis can be determined, for example, by measuring particle size distribution by a laser diffraction particle size distribution analyzer (manufactured by Beckman Coulter, Inc., LS 13 320), and then calculating a moment relative to the average value.

The soft magnetic particle powder has a particle size $D_{10}$ of 30 μm or more, preferably 40 μm or more, and for example, 100 μm or less, preferably 80 μm or less, more preferably 60 μm or less.

The soft magnetic particle powder has a particle size $D_{50}$ of 70 μm or more, preferably 80 μm or more, and for example, 200 μm or less, preferably 150 μm or less, more preferably 130 μm or less.

The ratio of the particle size $D_{10}$ to the particle size $D_{50}$, i.e., $D_{10}/D_{50}$ satisfies formula (2) below, preferably, formula (3) below.

$$D_{10}/D_{50} \; > 0.45 \quad (2)$$

$$D_{10}/D_{50} \; > 0.50 \quad (3)$$

The ratio $D_{10}/D_{50}$ satisfying the above-described formulas allows for a soft magnetic film highly filled with the soft magnetic particles, and a thin soft magnetic film more excellently.

Preferably, the ratio $D_{10}/D_{50}$ satisfies formula (4) below, more preferably, formula (5) below.

$$0.90 > D_{10}/D_{50} \quad (4)$$

$$0.70 > D_{10}/D_{50} \quad (5)$$

$D_{10}$ and $D_{50}$ are volume-based particle ratio, $D_{10}$ represents a particle size of a cumulative distribution of 10%, and $D_{50}$ represents a particle size of a cumulative distribution of 50%.

The $D_{10}$ and $D_{50}$ are measured, for example, by a laser diffraction particle size distribution analyzer (manufactured by Sympatec, HELOS & RODOS).

The soft magnetic particle powder can be produced by classifying a known or commercially available soft magnetic particle powder with, for example, a classifier such as a dry classifier, so that its distribution include only a specific particle size. To be specific, it can be produced by blowing air to the soft magnetic particle powder using a rotational vane of a dry classifier to blow away lightweight soft magnetic particles, and collect heavyweight soft magnetic particles.

The rotational vane has a rotational speed of, for example, 500 rpm or more, preferably 600 rpm or more, more preferably 800 rpm or more, and for example, 3000 rpm or less, preferably 2000 rpm or less, more preferably 1000 rpm or less.

The amount of air blown is, for example, 0.5 $m^3$/min or more, preferably 1.0 $m^3$/min or more, more preferably 1.4 $m^3$/min or more, and for example, 2.0 $m^3$/min or less, preferably 1.5 $m^3$/min or less.

The soft magnetic particle powder can also be produced by blowing air to the soft magnetic particle powder using a rotational vane of a dry classifier, and collecting the particles that are blown away.

2. Soft Magnetic Resin Composition

The soft magnetic resin composition of the present invention contains the soft magnetic particle powder and a resin component.

The resin component can contain any of a thermosetting resin and a thermoplastic resin, but preferably contains a thermosetting resin.

Examples of the thermosetting resin include epoxy resin, phenol resin, amino resin, unsaturated polyester resin, polyurethane resin, silicone resin, urea resin, melamine resin, thermosetting polyimide resin, and diallyl phthalate resin. Preferably, epoxy resin and phenol resin are used, and more preferably, epoxy resin and phenol resin are used in combination.

For the epoxy resin, for example, those which can be used as an adhesive composition can be used, including bisphenol epoxy resin (particularly, bisphenol A epoxy resin, bisphenol F epoxy resin, bisphenol S epoxy resin, brominated bisphenol A epoxy resin, hydrogenated bisphenol A epoxy resin, bisphenol AF epoxy resin, etc.), phenol epoxy resin (particularly, phenol novolak epoxy resin, ortho-cresol novolak epoxy resin, etc.), biphenyl epoxy resin, naphthalene epoxy resin, fluorene epoxy resin, trishydroxyphenylmethane epoxy resin, and tetraphenylolethane epoxy resin. Furthermore, for example, hydantoin epoxy resin, trisglycidylisocyanurate epoxy resin, and glycidylamine epoxy resin can also be used. These can be used singly or can be used in combination of two or more.

Of these examples of epoxy resin, preferably, bisphenol epoxy resin, more preferably, bisphenol A epoxy resin is used. Containing epoxy resin allows for excellent reactivity with phenol resin, and as a result, the soft magnetic film has excellent heat resistance. It also allows for decrease in gaps in the soft magnetic film, and allows the soft magnetic film to be highly filled with the soft magnetic particles.

Phenol resin is an epoxy resin curing agent, and for example, novolak phenol resins such as phenolnovolak resin, phenolaralkyl resin, cresol novolak resin, tert-butylphenolnovolak resin, and nonylphenolnovolak resin; resole phenol resin; and polyoxystyrenes such as polyparaoxystyrene are used. These can be used singly or can be used in combination of two or more.

Of these phenol resins, preferably, novolak resin, more preferably, phenolnovolak resin, phenolaralkyl resin, or even more preferably, phenolaralkyl resin is used. Containing these phenol resin allows for improvement in connection reliability of a soft magnetic film laminated circuit board produced by laminating the soft magnetic film on a circuit board.

When the hydroxyl equivalent of the phenol resin relative to 100 g/eq of the epoxy equivalent of the epoxy resin is 1 g/eq or more and less than 100 g/eq, the epoxy resin content relative to 100 parts by mass of the resin component is, for example, 15 parts by mass or more, preferably 30 parts by mass or more, and for example, 70 parts by mass or less and the phenol resin content relative to 100 parts by mass of the resin component is, for example, 5 parts by mass or more, preferably 15 parts by mass or more, and for example, 30 parts by mass or less.

When the hydroxyl equivalent of the phenol resin relative to 100 g/eq of the epoxy equivalent of the epoxy resin is 100 g/eq or more and less than 200 g/eq, the epoxy resin content relative to 100 parts by mass of the resin component is, for example, 10 parts by mass or more, preferably 25 parts by mass or more, and for example, 50 parts by mass or less, and the phenol resin content relative to 100 parts by mass of the resin component is, for example, 10 parts by mass or more, preferably 25 parts by mass or more, and for example, 50 parts by mass or less.

When the hydroxyl equivalent of the phenol resin relative to 100 g/eq of the epoxy equivalent of the epoxy resin is 200 g/eq or more and 1000 g/eq or less, the epoxy resin content relative to 100 parts by mass of the resin component is, for example, 5 parts by mass or more, preferably 15 parts by mass or more, and for example, 30 parts by mass or less, and the phenol resin content relative to 100 parts by mass of the resin component is, for example, 15 parts by mass or more, preferably 35 parts by mass or more, and for example, 70 parts by mass or less.

When two types of epoxy resins are used in combination, the epoxy equivalent is an epoxy equivalent of the total epoxy resins calculated by multiplying the epoxy equivalent of each of the epoxy resins by the mass ratio of each of the epoxy resins relative to t total amount of the epoxy resin, and adding these.

The hydroxyl equivalent of phenol resin per 1 equivalent of the epoxy group of the epoxy resin is, for example, 0.2 equivalent or more, preferably 0.5 equivalent or more, and for example, 2.0 equivalent or less, preferably 1.2 equivalent or less. When the amount of the hydroxyl group is within the above-described range, curing reaction of the soft magnetic film in semi-cured state will be excellent, and deterioration can be suppressed.

The resin component has a thermosetting resin content relative to 100 parts by mass of the resin component of, for example, 20 parts by mass or more, preferably 30 parts by mass or more, and for example, 90 parts by mass or less, preferably 80 parts by mass or less, more preferably 60 parts by mass or less.

The resin component contains, in addition to the thermosetting resin, preferably acrylic resin. More preferably, acrylic resin, epoxy resin, and phenol resin are used in combination. The resin component containing these resins allows for production of uniform and highly filled soft magnetic film without unevenness on lamination interface when a plurality of soft magnetic films in semi-cured state are laminated and heat-pressed to produce a sheet of soft magnetic film in cured state.

Examples of the acrylic resin include an acrylic polymer produced by polymerizing a monomer component of one or more alkyl (meth)acrylate having a straight chain or branched alkyl group. The "(meth)acryl" represents "acryl and/or methacryl".

Examples of the alkyl group include an alkyl group having 1 to 20 carbon atoms such as a methyl group, ether group, propyl group, isopropyl group, n-butyl group, t-butyl group, isobutyl group, amyl group, isoamyl group, hexyl group, heptyl group, cyclohexyl group, 2-ethylhexyl group, octyl group, isooctyl group, nonyl group, isononyl group, decyl group, isodecyl group, undecyl group, lauryl group, tridecyl group, tetradecyl group, stearyl group, octadecyl group, and dodecyl group. Preferably, an alkyl group having 1 to 6 carbon atoms is used.

The acrylic polymer can be a copolymer of alkyl (meth)acrylate and additional monomer.

Examples of the additional monomer include a glycidyl group-containing monomer such as glycidyl acrylate and glycidyl methacrylate; carboxyl group-containing monomers such as acrylic acid, methacrylic acid, carboxyethylacrylate, carboxypentylacrylate, itaconic acid, maleic acid, fumaric acid, and crotonic acid; acid anhydride monomers such as maleic anhydride and itaconic acid anhydride; hydroxyl group-containing monomers such as 2-hydroxyethyl (meth)acrylate, 2-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-(hydroxymethyl)cyclohexyl)methyl acrylate; sulfonic acid group-containing monomers such as styrenesulfonic acid, allylsulfonic acid, 2-(meth) acrylamide-2-methylpropanesulfonic acid, (meth) acrylamidepropanesulfonic acid, sulfopropyl (meth)acrylate, and (meth) acryloyloxynaphthalenesulfonic acid; phosphoric acid group-containing monomers such as 2-hydroxyethylacryloyl phosphate; styrene monomer; and acrylonitrile.

Among these, preferably, a glycidyl group-containing monomer, carboxyl group-containing monomer, or hydroxyl group-containing monomer is used. When the acrylic resin is a copolymer of alkyl (meth)acrylate and additional monomer of these, that is, when the acrylic resin contains a glycidyl group, carboxyl group, or hydroxyl group, the heat resistance of the soft magnetic film is excellent.

When the acrylic resin is a copolymer of alkyl (meth)acrylate and additional monomer, the mixing ratio (mass) of the additional monomer relative to the copolymer is preferably 40 mass% or less.

The acrylic resin has a weight-average molecular weight of, for example, $1 \times 10^5$ or more, preferably $3 \times 10^5$ or more, and for example, $1 \times 10^6$ or less. The weight-average molecular weight of the acrylic resin within this range allows for excellent adhesiveness and heat resistance of the soft magnetic film. The weight-average molecular weight is measured based on polystyrene standard calibration value by Gel Permeation Chromatography (GPC).

The acrylic resin has a glass transition temperature (Tg) of, for example, - 30°C or more, preferably -20°C or more, and for example, 30°C or less, preferably 15°C or less. The acrylic resin with a glass transition temperature (Tg) of the above-described lower limit or more allows for excellent adhesiveness of the soft magnetic film in semi-cured state. Meanwhile, the acrylic resin with a glass transition temperature (Tg) of the above-described upper limit or less allows for excellent handleability of the soft magnetic film. The glass transition temperature is obtained by the maximum value of loss tangent ($\tan\delta$) measured by using dynamic viscoelasticity measuring apparatus (DMA, frequency 1Hz, rising temperature speed 10°C/min).

When the resin component contains acrylic resin, the acrylic resin content relative to 100 parts by mass of the resin component is, for example, 10 parts by mass or more, preferably 20 parts by mass or more, more preferably 40 parts by mass or more, and for example, 80 parts by mass or less, preferably 70 parts by mass or less. The acrylic resin content within this range allows for excellent film-forming characteristics of the soft magnetic resin composition and adhesiveness of the soft magnetic film in semi-cured state.

The soft magnetic resin composition has a soft magnetic particle powder content of, for example, 50 mass% or more, preferably 60 mass% or more, more preferably 80 mass% or more, and for example, 98 mass% or less, preferably 95 mass% or less. The soft magnetic particle powder content within the above-described range allows for excellent relative magnetic permeability of the soft magnetic film.

The soft magnetic resin composition has a resin component content of, for example, 2 mass% or more, preferably 5 mass% or more, and for example, 50 mass% or less, preferably 20 mass% or less, more preferably 15 mass% or less. The resin component content within the above-described range allows for excellent film-forming characteristics of the soft magnetic resin composition.

The resin component can contain a resin other than the thermosetting resin and acrylic resin. An example of the resin other than the thermosetting resin and acrylic resin include a thermoplastic resin. These examples of the resin other than the thermosetting resin and acrylic resin can be used singly, or can be used in combination of two or more.

Examples of the thermoplastic resin include natural rubber, butyl rubber, isoprene rubber, chloroprene rubber, ethylene-vinyl acetate copolymer, polybutadiene resin, polycarbonate resin, thermoplastic polyimide resin, polyamide resin (6-nylon, 6,6-nylon, etc.), phenoxy resin, saturated polyester resin (PET, PBT, etc.), polyamide-imide resin, and fluorine resin.

The soft magnetic resin composition (and soft magnetic film) preferably contains, a thermosetting catalyst.

The thermosetting catalyst is not limited as long as the catalyst accelerates curing of the thermosetting resin by heating, and for example, an imidazole compound, triphenylphosphine compound, triphenylborane compound, and amino group-containing compound can be used. Preferably, an imidazole compound is used.

Examples of the imidazole compound include 2-phenylimidazole (trade name;2PZ), 2-ethyl-4-methylimidazole (trade name;2E 4MZ), 2-methylimidazole (trade name;2MZ), 2-undecylimidazole (trade name; C 11Z), 2-phenyl-4,5-dihydroxymethylimidazole (trade name; 2-PHZ), 2-phenyl-1H-imidazole 4,5-dimethanol (trade name; 2PHZ-PW), and 2,4-diamino-6-(2'-methylimidazolyl (1)') ethyl-s-triazine-isocyanuric acid adduct (trade name;2MAOK-PW) (the products with the trade names shown above are all manufactured by Shikoku Chemicals Corporation.).

The shape of the thermosetting catalyst includes spherical and ellipsoidal shapes.

These thermosetting catalysts can be used singly, or can be used in combination of two or more.

The mixing ratio of the thermosetting catalyst relative to 100 parts by mass of the resin component is, for example, 0.2 parts by mass or more, preferably 0.3 parts by mass or more, and for example, 5 parts by mass or less, preferably 2 parts by mass or less. When the mixing ratio of the thermosetting catalyst is in the above-described upper limit or less, the soft magnetic resin composition can achieve excellent storage stability for a long period of time under room temperature. Meanwhile, when the mixing ratio of the thermosetting catalyst is the lower limit or more, the soft magnetic film in semi-cured state can be heated and cured at a low temperature for a short period of time, and a soft magnetic film in cured state can be produced efficiently.

The soft magnetic resin composition can further contain, as necessary, an additional additive. Examples of the additive include a commercially available or known cross-linking agent and inorganic filler.

The soft magnetic resin composition is prepared by mixing the above-described component at the above-described mixing ratio.

3. Soft Magnetic Film

The soft magnetic film of the present invention is formed from the soft magnetic resin composition into a sheet.

The soft magnetic film can be produced from, for example, a preparation step in which a solution of a soft magnetic resin composition is prepared by dissolving or dispersing a soft magnetic resin composition in a solvent, a drying step in which the solution of a soft magnetic resin composition is applied on the surface of a release substrate and dried to produce a soft magnetic film in semi-cured state, and a heat-pressing step in which a plurality of soft magnetic films in semi-cured state are laminated and heat-pressed.

First, the soft magnetic resin composition is dissolved or dispersed in a solvent (preparation step). A solution of the soft magnetic resin composition is prepared in this manner.

Examples of the solvent include organic solvents including ketones such as acetone and methyl ethyl ketone (MEK), esters such as ethyl acetate; amides such as N,N-dimethylformamide; and ethers such as propylene glycol monomethyl ether. Examples of the solvent also include water, and water-based solvents such as alcohols including methanol, ethanol, propanol, and isopropanol.

The solution of the soft magnetic resin composition has a solid content amount of, for example, 5 mass% or more, preferably 10 mass% or more, and for example, 50 mass% or less, and preferably 20 mass% or less.

The solution of the soft magnetic resin composition is prepared in this manner.

Then, the solution of the soft magnetic resin composition is applied on the surface of the release substrate and dried (drying step).

Examples of the release substrate include a separator and a core material.

Examples of the separator include a polyethylene terephthalate (PET) film, polyethylene film, polypropylene film, and paper. Surfaces of these are treated with, for example, a fluorine release agent, a long-chain alkylacrylate release agent, and a silicone release agent.

Examples of the core material include a plastic film (for example, polyimide film, polyester film, polyethylene terephthalate film, polyethylenenaphthalate film, polycarbonate film, etc.), metal film (for example, aluminum foil, etc.), a resin substrate reinforced with glass fiber or plastic-made nonwoven fiber, silicon substrate, and glass substrate.

The separator or the core material has an average thickness of, for example, 1 $\mu$m or more and 500 $\mu$m or less.

The application method is not particularly limited, and examples thereof include doctor blade method, roll application, screen application, and gravure application.

The drying conditions are as follows: a drying temperature of, for example, 70°C or more and 160°C or less, and a drying time of, for example, 1 minute or more and 5 minutes or less.

A soft magnetic film in semi-cured state is produced in this manner.

The soft magnetic film is in semi-cured state (B-stage state) at room temperature (to be specific, 25°C), and is a soft magnetic adhesive film having excellent adhesiveness.

The soft magnetic film (semi-cured state) has an average film thickness of, for example, 500 $\mu$m or less, preferably 300 $\mu$m or less, more preferably 200 $\mu$m or less, even more preferably, 150 $\mu$m or less, most preferably 100 $\mu$m or less, and for example, 5 $\mu$m or more, preferably 50 $\mu$m or more.

Then, a plurality of the produced soft magnetic films in semi-cured state are prepared, and the plurality of soft magnetic films are heat-pressed with a heat press in the thickness direction (heat-pressing step).

The heat-pressing can be performed by using a known press, and for example, a parallel plate press is used.

For example, two layers or more, and 20 layers or less, preferably 5 layers or less of the soft magnetic films (semi-cured state) are laminated. The soft magnetic film can be adjusted to have a desired film thickness in this manner.

The heating temperature is, for example, 80°C or more, preferably 100°C or more, and for example, 200°C or less, preferably 175°C or less.

The heating time is, for example, 0.1 hour or more, preferably 0.2 hours or more, and for example, 24 hours or less, preferably 3 hours or less, more preferably 2 hours or less.

The pressure is, for example, 10MPa or more, preferably 20MPa or more, and for example, 500MPa or less, preferably 200MPa or less. In this manner, the soft magnetic film highly filled with soft magnetic particles, and a thin soft magnetic film can be achieved more excellently.

A soft magnetic film in cured state (C stage-state) is produced in this manner.

The soft magnetic film has a film thickness of, for example, 5 $\mu$m or more, preferably 50 $\mu$m or more, and for example, 500 $\mu$m or less, preferably 250 $\mu$m or less.

The filling rate of the soft magnetic particles (volume percentage, excluding gaps, of the soft magnetic particles accounting for the solid content in the soft magnetic film) relative to the solid content of the soft magnetic film is, for example, 60% by volume or more, preferably 63% by volume or more, and for example, 95% by volume or less, preferably 90% by volume or less. This allows for excellent relative magnetic permeability of the soft magnetic film. The soft magnetic particles filling rate is described in detail in Examples.

In the soft magnetic film, the soft magnetic particles contained in the soft magnetic film are preferably arranged in a 2-dementional in-plane direction of the soft magnetic film. That is, a longitudinal direction (direction perpendicular to thickness direction) of the flat soft magnetic particles is oriented to be along the surface direction of the soft magnetic film (ref: FIG. 1A). Thus, the soft magnetic film is a thin film and has excellent relative magnetic permeability.

The soft magnetic film has a relative magnetic permeability of, for example, 220 or more, preferably 250 or more, more preferably 280 or more.

The soft magnetic film can be, for example, a single layer structure composed only of a single layer of the soft magnetic film, a multiple layer structure in which the soft magnetic film is laminated on one side or both sides of the core material, or a multiple layer structure in which a separator is laminated on one side or both sides of the soft magnetic film.

Although the plurality of soft magnetic films in semi-cured state are laminated and heat-pressed in the above-described embodiment, for example, the heat-pressing can be performed on a single soft magnetic film in semi-cured state (single layer).

Furthermore, although the soft magnetic film in semi-cured state is heat-pressed in the above-described embodiment, the heat-pressing does not have to be performed. That is, the soft magnetic film can be used as it is in the semi-cured state. The surface of the soft magnetic film in semi-cured state is adhesive, and therefore can be directly laminated on a circuit board (described later), for example, without using an adhesive. Thereafter, as necessary, curing can be performed to produce a soft magnetic film in cured state.

4. Soft Magnetic Film Laminated Circuit Board

A soft magnetic film laminated circuit board of the present invention is produced by laminating the soft magnetic film on a circuit board.

For example, as shown in FIG. 1A to FIG. 1C, the soft magnetic film laminated circuit board of the present invention is produced by a step of preparing a soft magnetic film 1 and a circuit board 2, a step of laminating the circuit board 2 and an adhesive layer 3, and a step of laminating the soft magnetic film 1 onto the adhesive layer 3.

In this method, first, as shown in FIG. 1A, the soft magnetic film 1 and the circuit board 2 are prepared. To be more specific, the soft magnetic film 1 and the circuit board 2 in which a wiring pattern 4 is formed on the surface of a substrate 5 are prepared.

The soft magnetic film 1 is the one as described above, and includes a resin component 6, and soft magnetic particles 7 contained in the resin component 6. The soft magnetic particles 7 are arranged, preferably 2-dementional in-plane direction of the soft magnetic film 1.

The circuit board 2 is, for example, a circuit board in which an electromagnetic induction system is used, and has a wiring pattern 4 of, for example, a loop coil formed on one side of the substrate 5. The wiring pattern 4 is composed of a metal material such as copper, and is formed by, for example, a semi-additive method or a subtractive method.

Examples of the insulating material that forms the substrate 5 include a glass epoxy substrate, glass substrate, PET substrate, Teflon substrate, ceramics substrate, and polyimide substrate.

Then, as shown in FIG. 1B, the adhesive layer 3 is laminated on the circuit board 2. To be more specific, for example, an adhesive is applied on the surface of the circuit board 2 so as to cover the top face and the side face of the wiring pattern 4.

For the adhesive that formed the adhesive layer 3, a known, generally used one as the adhesive layer 3 of the circuit board 2 is used, and for example, adhesives such as an epoxy adhesive, polyimide adhesive, and acrylic adhesive are used. The adhesive layer 3 has a thickness of, for example, 10 to 100 $\mu$m.

Then, as shown in FIG. 1C, the soft magnetic film 1 is laminated on the adhesive layer 3. To be specific, the soft magnetic film 1 is brought into contact with the surface of the adhesive layer 3.

In this manner, a soft magnetic film laminated circuit board 8 on which the soft magnetic film 1 is laminated on the circuit board 2 is produced.

The soft magnetic film laminated circuit board 8 can be used for various use, and for example, can be used for a position detection device, smartphone, and personal computer.

Although the soft magnetic film 1 is laminated on the circuit board 2 with the adhesive layer 3 therebetween in the soft magnetic film laminated circuit board 8 of the embodiment of FIG. 1A to FIG. 1C, for example, although not shown, the soft magnetic film 8 can be directly laminated on the circuit board 2 without the adhesive layer 3 interposed therebetween.

In this case, by curing the soft magnetic film 1 after laminating the soft magnetic film in semi-cured state 1 on the circuit board 2 so that the surface (top face and side face) of the wiring pattern 4 is covered (embedded) with the soft magnetic film 1, the soft magnetic film laminated circuit board 8 can be produced.

5. Position detection device

A position detection device of the present invention includes, for example, a sensor substrate including the above-described soft magnetic film laminated circuit board and a sensor unit mounted on the soft magnetic film laminated circuit board, and a position detection flat plate disposed to face on the sensor substrate.

Examples of the method for a reflowing step at the time of mounting the sensor unit on the soft magnetic film laminated circuit board include hot-air reflowing and infrared reflowing. Either entire heating or partial heating can be performed.

The heating temperature in the reflowing step is, for example, 200°C or more, preferably 240°C or more, and for example, 300°C or less, preferably 265°C or less. The heating time is, for example, 1 second or more, preferably 5 seconds or more, more preferably 30 seconds or more, and for example, 2 minutes or less, preferably 1.5 minutes or less.

By disposing the position detection flat plate on the sensor substrate produced as described above in spaced-apart relation so as to face thereto, the position detection device is produced.

The soft magnetic particle powder is composed with flat soft magnetic particles and the soft magnetic particle powder has a kurtosis of more than -0.35, and therefore when a soft magnetic film is formed from a soft magnetic resin composition containing the soft magnetic particle powder and the resin component, the soft magnetic film can contain the soft magnetic particles with a high filling rate. The soft magnetic film can be made thinner as well. Therefore, a thin soft magnetic film can be achieved with excellent relative magnetic permeability.

With the soft magnetic particle powder, a soft magnetic film with excellent relative magnetic permeability can be produced without necessitating surface treatment to the soft magnetic particles.

Furthermore, the soft magnetic film laminated circuit board and position detection device including the soft magnetic film can be made small and achieve efficiency, because the soft magnetic film can be thin and have excellent relative magnetic permeability.

EXAMPLES

In the following, the present invention will be described in detail with Examples and Comparative Examples, but the present invention is not limited thereto. Values in Examples can be replaced with the values described in the embodiments above (that is, upper limit value or lower limit value).

EXAMPLE 1

(Classification of soft magnetic particle powder)

Sendust (Fe-Si-Al alloy, trade name "SP-7", flat, manufactured by MATE CO., LTD, coercive force 67A/m) was used for the flat soft magnetic particle powder. Using a dry classifier (manufactured by NISSHIN ENGINEERING INC., turbo classifier TC-15NS), air was blowing onto the soft magnetic particle powder under conditions of a rotational vane rotational speed of 1850 rpm and an air flow rate of 1.5 $m^3$/min. Lightweight particles were blown off, and heavyweight particles were collected, thereby producing soft magnetic particle powder of Example 1.

The soft magnetic particle powder (Sendust) of Example 1 was subjected to particle size distribution measurement using a laser diffraction particle size distribution analyzer (manufactured by Beckman Coulter, Inc., LS 13 320). Afterwards, the kurtosis was determined by calculating a moment relative to the average value.

[Mathematical Formula 1]

$$\text{(Kurtosis)} = \frac{\sum \left| f_i (\ln x_i - \ln \bar{x})^4 \right|}{\left( \ln SD^4 \sum f_i \right)} - 3$$

$X_i$ represents an average value of particle size of i-th channel (predetermined region on x-axis)
$\bar{X}$ represents average particle size
$f_i$ represents volume percentage of the particle
SD represents standard deviation and is represented by formula below

[Mathematical Formula 2]

$$SD = \exp \left[ \sqrt{\frac{\sum \left| f_i (\ln x_i - \ln \bar{x})^2 \right|}{\sum f_i}} \right]$$

The soft magnetic particle powder of Example 1 had a kurtosis of -0.30.

Then, particle sizes $D_{10}$ and $D_{50}$ of the soft magnetic particle powder of Example 1 were measured using a laser diffraction particle size distribution analyzer (manufactured by Sympatec, HELOS & RODOS). Table 1 shows the results.

(Soft magnetic film)

Then, by mixing 1150 parts by mass (92 mass%) of the soft magnetic particle powder of Example 1, 50 parts by mass of acrylate ester polymer, 20 parts by mass of bisphenol A epoxy resin (1), 12 parts by mass of bisphenol A epoxy resin (2), 18 parts by mass of phenol aralkyl resin, and 0.5 parts by mass of thermosetting catalyst, a soft magnetic resin composition was produced.

The soft magnetic resin composition was dissolved in methyl ethyl ketone, thereby preparing a solution of the soft magnetic resin composition having a solid content concentration of 12 mass%.

The solution of the soft magnetic resin composition was applied using an applicator on a separator (average thickness 50 μm) composed of a polyethylene terephthalate film to which silicone release treatment was given, and thereafter, dried at 130°C for 2 minutes.

In this manner, a soft magnetic film in semi-cured state on which a separator was laminated (average thickness of only soft magnetic film 35 μm) was produced.

Two soft magnetic films (semi-cured state) were produced, and these soft magnetic films (excluding separators) were laminated. The two laminated soft magnetic films were heat pressed at 100MPa and 175°C for 30 minutes, thereby producing a soft magnetic film (cured state) having a thickness of 60 μm.

EXAMPLE 2

Classification was performed in the same manner as in Example 1, except that conditions of the dry classifier were changed to a rotational vane rotational speed of 1100 rpm and an air flow rate of 1.4 m$^3$/min, thereby producing the soft magnetic particle powder of Example 2. A soft magnetic film was produced in the same manner as in Example 1, except that the soft magnetic particle powder of Example 2 was used. Table 1 shows the result.

EXAMPLE 3

Classification was performed in the same manner as in Example 1, except that conditions of the dry classifier were changed to a rotational vane rotational speed of 850 rpm and an air flow rate of 1.4 m$^3$/min, thereby producing soft magnetic particle powder of Example 3. A soft magnetic film was produced in the same manner as in Example 1, except that the soft magnetic particle powder of Example 3 was used. Table 1 shows the result.

EXAMPLE 4

Classification was performed in the same manner as in Example 1, except that conditions of the dry classifier were changed to a rotational vane rotational speed of 720 rpm and an air flow rate of 1.1 m$^3$/min, and lightweight particles were collected, thereby producing soft magnetic particle powder of Example 4. A soft magnetic film was produced in the same manner as in Example 1, except that the soft magnetic particle powder of Example 4 was used. Table 1 shows the result.

Comparative Example 1

Classification was performed in the same manner as in Example 1, except that conditions of the dry classifier were changed to a rotational vane rotational speed of 1850 rpm and an air flow rate of 1.5 m$^3$/min, and lightweight particles were collected, thereby producing soft magnetic particle powder of Comparative Example 1. A soft magnetic film was produced in the same manner as in Example 1, except that the soft magnetic particle powder of Comparative Example 1 was used. Table 1 shows the result.

Comparative Example 2

Classification was performed in the same manner as in Example 1, except that conditions of the dry classifier were changed to a rotational vane rotational speed of 950 rpm and an air flow rate of 1.3 m$^3$/min, and lightweight particles were collected, thereby producing soft magnetic particle powder of Comparative Example 2. A soft magnetic film was produced in the same manner as in Example 1, except that the soft magnetic particle powder of Comparative Example 2 was used. Table 1 shows the result.

Comparative Example 3

A soft magnetic film was produced in the same manner as in Example 1, except that Sendust (trade name "SP-7", manufactured by MATE CO., LTD) was used without classification. Table 1 shows the result.

Comparative Example 4

Classification was performed in the same manner as in Example 1, except that conditions of the dry classifier were changed to a rotational vane rotational speed of 1050 rpm and an air flow rate of 1.7m$^3$/min, thereby producing soft magnetic particle powder of Comparative Example 4. A soft magnetic film was produced in the same manner as in Example 1, except that the soft magnetic particle powder of Comparative Example 4 was used. Table 1 shows the result.

(Filling rate)

The filling rate (volume percentage) of the soft magnetic film produced in Examples and Comparative Example 1 was determined. To be specific, the density of the produced soft magnetic film was measured using Archimedes' principle, and the measured density was used for calculation using the formula below. Table 1 shows the result.

[Mathematical formula 3]

(Filling rate)

$$= \frac{(\text{Measured Density}) - (\text{Resin Component Density})}{(\text{Soft Magnetic Particle Density}) - (\text{Resin Component Density})}$$

(Relative magnetic permeability)

The relative magnetic permeability of the soft magnetic film produced in Examples and Comparative Example was measured by measuring an impedance at 1MHz using an impedance analyzer (manufactured by Agilent, product number "4294A"). Table 1 shows the result.

[Table 1]

| | | Example 1 | Example 2 | Example 3 | Example 4* | Comparative Example 1 | Comparative Example 2 | Comparative Example 3 | Comparative Example 4 |
|---|---|---|---|---|---|---|---|---|---|
| Soft magnetic particle powder | Kurtosis | -0.30 | -0.15 | 0.21 | 0.07 | -0.57 | -0.50 | -0.38 | -0.40 |
| | D10(μm) | 37 | 41 | 55 | 20 | 2 | 5 | 28 | 38 |
| | D50(μm) | 76 | 81 | 104 | 59 | 17 | 38 | 73 | 82 |
| | D10/D50 | 0.48 | 0.51 | 0.53 | 0.34 | 0.14 | 0.14 | 0.38 | 0.46 |
| Filling rate (% by volume) | | 61.4 | 61.5 | 63.4 | 60.1 | 57.0 | 57.8 | 59.0 | 59.2 |
| Relative magnetic permeability | | 250 | 256 | 301 | 225 | 160 | 171 | 206 | 217 |

*Reference Example

For the components in Examples and Comparative Example, the following were used.

- Acrylate ester polymer: trade name "Paracron W-197CM", acrylate ester polymer mainly composed of ethyl acrylate-methyl methacrylate, manufactured by Negami Chemical Industrial Co., Ltd.
- Bisphenol A epoxy resin (1): trade name "Epikote 1004", epoxy equivalent 875 to 975 g/eq, manufactured by JER,
- Bisphenol A epoxy resin (2): trade name, "Epikote YL 980", epoxy equivalent 180 to 190 g/eq, manufactured by JER
- Phenolaralkyl resin: trade name "MILEX XLC-4 L", hydroxyl equivalent 170 g/eq, manufactured by Mitsui Chemicals
- Thermosetting catalyst: trade name "CUREZOL 2PHZ-PW", 2-phenyl-1H-imidazole 4,5-dimethanol, manufactured by Shikoku Chemicals Corporation.

While the illustrative embodiments of the present invention are provided in the above description, such is for illustrative purpose only and it is not to be construed restrictively. Modification and variation of the present invention that will be obvious to those skilled in the art is to be covered by the following claims.

Industrial Applicability

The soft magnetic particle powder, soft magnetic resin composition, soft magnetic film, soft magnetic film laminated circuit board, and position detection device of the present invention can be applied to various industrial products. For example, the soft magnetic particle powder, soft magnetic resin composition, soft magnetic film, and soft magnetic film laminated circuit board of the present invention can be used for a position detection device, and the position detection device of the present invention can be used, for example, for mobile terminals such as smartphones and tablet computers, and for example, a digitizer.

Description of reference numeral

1    Soft magnetic film
2    Circuit board
6    Resin component
7    Soft magnetic particles
8    Soft magnetic film laminated circuit board

**Claims**

1.  Soft magnetic particle powder composed of flat soft magnetic particles,
    wherein the soft magnetic particle powder has a kurtosis of more than -0.35, **characterized in that** the particle size $D_{10}$ and the particle size $D_{50}$ as measured by a laser diffraction particle size distribution analyzer satisfy the formula

$$D_{10}/D_{50} > 0.45,$$

$D_{50}$ is 70 $\mu$m or more, and
$D_{10}$ is 30 $\mu$m or more,
and a kurtosis is determined by calculating a moment relative to the average value using the following formula:

$$(\text{Kurtosis}) = \frac{\sum \left| f_i (\ln x_i - \ln \bar{x})^4 \right|}{\left( \ln SD^4 \sum f_i \right)} - 3$$

$X_i$ represents an average value of particle size of i-th channel (predetermined region on x-axis)
$\bar{X}$ represents average particle size
$f_i$ represents volume percentage of the particle
SD represents standard deviation and is represented by formula below

$$SD = \exp\left[\sqrt{\frac{\sum\left|f_i(\ln x_i - \ln \bar{x})^2\right|}{\sum f_i}}\right]$$

.

2. The soft magnetic particle powder according to Claim 1, wherein the particle size $D_{10}$ and the particle size $D_{50}$ as measured by a laser diffraction particle size distribution analyzer satisfy the formula:

$$0.70 > D_{10}/D_{50}.$$

3. A soft magnetic resin composition containing the soft magnetic particle powder of claim 1 and a resin component.

4. The soft magnetic resin composition according to Claim 3, wherein the resin component contains epoxy resin, phenol resin, and acrylic resin.

5. A soft magnetic film formed from a soft magnetic resin composition containing the soft magnetic resin composition of claim 3.

6. A soft magnetic film laminated circuit board produced by laminating, on a circuit board, the soft magnetic film of claim 5.

7. A position detection device including the soft magnetic film laminated circuit board of claim 6.


**Patentansprüche**

1. Weichmagnetpulver bestehend aus flachen weichmagnetischen Partikeln,
wobei das Weichmagnetpulver eine Kurtosis von mehr als -0,35 aufweist, dadurch charakterisiert, dass die Partikelgröße $D_{10}$ und die Partikelgröße $D_{50}$, gemessen mittels eines Laserbeugungs-Teilchengrößenverteilungsanalysators, die Formel erfüllen:

$$D_{10}/D_{50} > 0,45,$$

$D_{50}$ beträgt 70 $\mu$m oder mehr, und
$D_{10}$ beträgt 30 $\mu$m oder mehr,
und eine Kurtosis bestimmt wird, indem ein Moment in Bezug auf den Durchschnittswert unter Verwendung der folgenden Formel berechnet wird:

$$(\text{Kurtosis}) = \frac{\sum\left|f_i(\ln x_i - \ln \bar{x})^4\right|}{\left(\ln SD^4 \sum f_i\right)} - 3$$

$X_i$ stellt einen Durchschnittswert der Partikelgröße des Kanals i dar (vorbestimmte Region auf der x-Achse)
$\overline{X}$ stellt die durchschnittliche Partikelgröße dar
$f_i$ stellt den Volumenprozentanteil der Partikel dar
SD stellt die Standardabweichung dar und wird durch die nachstehende Formel dargestellt

$$SD = \exp\left[\sqrt{\frac{\sum\left|f_i(\ln x_i - \ln \bar{x})^2\right|}{\sum f_i}}\right].$$

**2.** Weichmagnetpulver gemäß Anspruch 1, wobei die Partikelgröße $D_{10}$ und die Partikelgröße $D_{50}$, gemessen mittels eines Laserbeugungs-Teilchengrößenverteilungsanalysators, die Formel erfüllen:

$$0,70 > D_{10}/D_{50}.$$

**3.** Weichmagnetische Harzzusammensetzung enthaltend das Weichmagnetpulver gemäß Anspruch 1 und eine Harzkomponente.

**4.** Weichmagnetische Harzzusammensetzung gemäß Anspruch 3, wobei die Harzkomponente ein Epoxidharz, ein Phenolharz und ein Acrylharz enthält.

**5.** Weichmagnetfilm gebildet aus einer weichmagnetischen Harzzusammensetzung enthaltend die weichmagnetische Harzzusammensetzung gemäß Anspruch 3.

**6.** Mit einem Weichmagnetfilm laminierte Leiterplatte hergestellt durch Laminieren des Weichmagnetfilms gemäß Anspruch 5 auf die Leiterplatte.

**7.** Positionserfassungsvorrichtung, enthaltend die mit einem Weichmagnetfilm laminierte Leiterplatte gemäß Anspruch 6.

**Revendications**

**1.** Poudre de particules magnétiques à faible champ coercitif composée de particules magnétiques à faible champ coercitif plates,
dans laquelle la poudre de particules magnétiques à faible champ coercitif présente un aplatissement de plus de -0,35, **caractérisé en ce que** la taille de particules $D_{10}$ et la taille de particules $D_{50}$ telles que mesurées par un analyseur de distribution de taille de particules par diffraction laser satisfont la formule

$$D_{10}/D_{50} > 0,45,$$

$D_{50}$ est de 70 $\mu$m ou plus, et
$D_{10}$ est de 30 $\mu$m ou plus,
et un aplatissement est déterminée en calculant un moment relatif à la valeur moyenne en utilisant la formule suivante :

$$(\text{Aplatissement}) = \frac{\sum\left|f_i(\ln x_i - \ln \bar{x})^4\right|}{\left(\ln SD^4 \sum f_i\right)} - 3$$

$X_i$ représente une valeur moyenne de taille de particules d'un $i^{\text{ème}}$ canal (région prédéterminée sur un axe x)
$X$ représente une taille de particules moyenne
$f_i$ représente le pourcentage en volume de la particule
SD représente l'écart type et est représenté par la formule ci-dessous

$$SD = \exp\left[\sqrt{\frac{\sum \left|f_i(\ln x_i - \ln \bar{x})^2\right|}{\sum f_i}}\right]$$

.

2. Poudre de particules magnétiques à faible champ coercitif selon la revendication 1, dans laquelle la taille de particules $D_{10}$ et la taille de particules $D_{50}$ telles que mesurées par un analyseur de distribution de taille de particules par diffraction laser satisfont la formule :

$$0,70 > D_{10}/D_{50}.$$

3. Composition de résine magnétique à faible champ coercitif contenant la poudre de particules magnétiques à faible champ coercitif selon la revendication 1 et un composant de résine.

4. Composition de résine magnétique à faible champ coercitif selon la revendication 3, dans laquelle le composant de résine contient une résine époxy, une résine phénolique, et une résine acrylique.

5. Film magnétique à faible champ coercitif formé à partir d'une composition de résine magnétique à faible champ coercitif contenant la composition de résine magnétique à faible champ coercitif selon la revendication 3.

6. Carte de circuits imprimés stratifiée à film magnétique à faible champ coercitif produite en stratifiant, sur une carte de circuits imprimés, le film magnétique à faible champ coercitif selon la revendication 5.

7. Dispositif de détection de position incluant la carte de circuits imprimés stratifiée à film magnétique à faible champ coercitif selon la revendication 6.

FIG.1A

FIG.1B

FIG.1C

**EP 3 059 744 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- JP 6041602 A
- JP 2005041602 A
- JP H11260616 A
- JP 2009267237 A
- US 5651481 A
- JP 2006039947 A
- JP 2005310952 A